# EUROPEAN PATENT APPLICATION

(11) **EP 1 484 790 A1**
(43) Date of publication of application: **08.12.2004**
(21) Application number: 01275101.2
(22) Date of filing: 25.12.2001
(51) Int. Cl.: H01L 21/301

(54) **SEMICONDUCTOR DEVICE AND METHOD FOR FABRICATING THE SAME**

(71) Applicant: Hitachi, Ltd., Chiyoda-ku, Tokyo 101-8010 (JP)
(72) Inventor: TASE, Takashi, Hitchi, Ltd., Kokubunji-shi, Tokyo 185-8601 (JP); SATO, Akira, Hitchi, Ltd., Kokubunji-shi, Tokyo 185-8601 (JP)
(74) Representative: Strehl Schübel-Hopf & Partner
(86) International application number: PCT/JP2001/011366
(87) International publication number: WO 2003/056613

(57) **Abstract**

The main object of the present invention is to provide a semiconductor device (LSI chip) in which chippings (chippings at cut surface edges) do not occur or are reduced to an practically allowable level even if they occur at the time of separating LSI chips from a wafer by dicing and a method for fabricating the same.

In order to achieve the above object, a semiconductor device of the invention is characterized in that at least edge portions of a surface on which a device is formed of a semiconductor chip and a back surface thereof are chamfered to have a slant surface having a chamfering slant angle θ, respectively, where 90° < θ < 180°.

A more preferable chamfering slant angle θ is not less than 100° and not more than 135° and further it is the most practically preferable that all of the chamfering slant angles of four sides of the semiconductor chip are about 135°.

According to this invention, it is possible to prevent the outer peripheral edge portions of the LSI chips from being chipped at the time of separating the LSI chips from the wafer by dicing. Hence, if this chip is_mounted on an IC card or an IC tag, it is possible to reduce material cost and fabrication time by a simple structure and, in particular, to realize a low-profile IC card that is as highly reliable even without a reinforcing board as in a state with the reinforcing board in the mounting of the LSI chip on the IC card, and an IC tag that has high yield and high reliability in the mounting of the LSI on the IC tag, respectively.

## Description

### Background of the Invention and Related Art Statement

The present invention relates to a semiconductor device and a method for fabricating the same and, in particular, to semiconductor device suitable for an LSI (large scale integration) chip required to have high reliability such as a low-profile IC (integrated circuit) card and IC tag and a method for fabricating the same.

A background art will be described below by taking a case where an LSI chip is used for an IC card as an example.

A method for fabricating a conventional IC card is disclosed, for example, in Japanese Unexamined Patent Publication No. 11-296642. Figs. 1(a) and (b) are a plan view and a cross sectional view to show the structure of a conventional IC card.

First, a reinforcing board 350 is overlain on a back side where a device of a semiconductor chip 230 separated from a wafer by dicing is not formed.

Next, a bump 340 formed on the semiconductor chip 230 via an anisotropic conductive adhesive 310 stuck on a silver paste wiring 330 formed on a polyethylene terephthalate material (hereinafter abbreviated as PET material) 380 which becomes a card mother board is bonded and fixed to the silver paste wiring 330 so that the bump 34 and the silver paste wiring 330 are connected to each other.

The above-described conventional method has the following problem. That is,'many chippings (chipped cut surface edges) occur on the back side, or a side from which a dicing blade is withdrawn, of the semiconductor chip separated from a wafer by dicing and if a bending test which is an item of reliability test of an IC card is conducted in this state, the chip is broken at portions chipped off by the dicing.

In order to prevent the chip from being broken, the chip 230 needs to have rigidity and hence the reinforcing board 350 is mounted on the back of the chip 230. However, even if the IC card is constructed of such a reinforcing board, a wiring board (the PET material 380 of the mother board also serves as a wiring board) is brought into contact with the edge portions of the reinforcing board 250 by conducting the bending test or the like to break the wiring board to jump out the reinforcing board 350 from the PET material 380 to cause stress in the semiconductor chip, thereby breaking the semiconductor chip.

Moreover, since the thickness of a spacer in the IC card needs to be increased because the reinforcing board 350 is mounted, material cost is increased and a process and a time required to fabricate the card needs to be elongated to increase cost. Further, reinforcing the card with a board presents a problem of limiting the thickness of the card.

In addition, even in the mounting of an IC tag, a semiconductor chip separated from a wafer by dicing is used and hence the problem that the chip is broken by the generation of a minute chip caused by dicing is a common important problem.

### Objects and Summary of the Invention

Therefore, the object of the present invention is to solve the above-described problems in the related art, and to provide a semiconductor device (LSI chip) in which chippings (chippings at cut surface edges) do not occur or are reduced to an practically allowable level even if they occur at the time of separating an LSI chip from a wafer by dicing and a method for fabricating the same.

To be more specific, the object of the invention is to provide an IC card and an LSI tag capable of reducing material cost and fabrication time in the mounting of an LSI on the IC card and the LSI tag by a simple structure by preventing the occurrence of chipping at the outer peripheral edge portions of the LSI chip at the time of separating the LSI and, in particular, to provide a low-profile IC card that is as highly reliable even without a reinforcing board as in a state with the reinforcing board in the mounting of the LSI chip on the IC card, and an IC tag that has high yield and high reliability in the mounting of the LSI on the IC tag, respectively.

In order to achieve the above object, a semiconductor device of the invention is characterized in that at least edge portions of a surface on which a device is formed of a semiconductor chip and a back surface thereof are chamfered to have a slant surface having a chamfering slant angle θ, respectively, where 90° < θ < 180°.

A more preferable chamfering slant angle θ is not less than 100° and not more than 135° and further it is the most practically preferable that all of the chamfering slant angles of four sides of the semiconductor chip are about 135°.

The outline of a method for fabricating the above-described semiconductor device will be described.

The method for fabricating the above-described semiconductor device is a method for forming grooves of a predetermined depth on a surface on which devices are formed of the semiconductor wafer and a back surface thereof by use of a dicing blade having a sharp tip with reference to a scribing line on the surface on which the semiconductor devices are formed of the wafer at the time of separating the semiconductor chips from the semiconductor wafer along the scribing line by use of the dicing blade.

Thereafter, a dicing blade having a sharper tip is aligned with the centers of the formed grooves and then the semiconductor wafer is separated into the individual semiconductor chips. The semiconductor chips are fabricated in which the edge portions of the front and back surfaces are chamfered. The slant angle formed by chamfering the edge portions of the front and back surfaces of the semiconductor chip can be adjusted by selecting the angle of blade tip (vertical angle) θ' of the dicing blade used for forming the grooves.

For example, in the case of using a dicing blade having a vertical angle θ' ranging from 20° to 90° at the blade tip, the semiconductor chip having edge portions each having a chamfering slant angle which is not less than 100° and not more than 135° can be cut and separated. Therefore, in the case of using the dicing blade having a vertical angle θ' ranging from 20° to 90° at the blade tip, the slant angles of four sides of the separated semiconductor chip become 135°, respectively.

In this regard, if dicing blades having different angles (vertical angles) θ' at the blade tip are used at the time of forming the grooves on both surfaces of the wafer, the semiconductor chip are produced in which edge portions are chamfered at different slant angles for the front and back surfaces.

Here, the characteristics of the typical method of the invention for fabricating the above-described semiconductor device will be described.

A first fabricating method is characterized in that it is such a method for fabricating a semiconductor device that includes a step of cutting and separating a semiconductor chip from a semiconductor wafer by dicing, and in that the dicing includes: a step of forming a first groove having a depth of at least 1/2 of the thickness of the semiconductor chip along a scribing line from one surface of the semiconductor wafer by use of a first dicing blade having a predetermined vertical angle θ'; and a step of forming a second groove along the scribing line by use of a second dicing blade having predetermined vertical angle θ' from a back surface of the semiconductor wafer.

A second fabricating method is characterized in that it is such a method for fabricating a semiconductor device that includes a step of cutting and separating a semiconductor chip from a semiconductor wafer and includes dicing, and in that the step of cutting and separating the semiconductor chip includes: a step of forming a groove having a depth of at least 1/2 of the thickness of the semiconductor chip along a scribing line from one surface of the semiconductor wafer by use of a dicing blade having a predetermined vertical angle θ'; and a step of turning the semiconductor wafer upside down and applying pressure to a back surface of the semiconductor wafer to cleave and separate the semiconductor chip at the groove.

A third fabricating method is characterized in that it is such a method for fabricating a semiconductor device that includes a step of cutting and separating a semiconductor chip from a semiconductor wafer and includes dicing, and in that the step of cutting and separating the semiconductor chip includes: a step of forming a groove having a depth of at least 1/2 of the thickness of the semiconductor chip along a scribing line from one surface of the semiconductor wafer by use of a dicing blade having a predetermined vertical angle θ'; and a step of separating the semiconductor chip at the groove by dry etching.

If this semiconductor chip is used, for example, for an IC chip, because the semiconductor chip chamfered at the edge portion of the front and back surfaces of the chip is fabricated, it is possible to produce an IC card that has excellent mechanical strength even without using a reinforcing board and high reliability.

Moreover, if this semiconductor chip is mounted on an IC tag, it is possible to produce an IC tag that has high mounting yield and high reliability.

### Brief Description of the Drawings

Fig. 1 is an illustration to show a method for fabricating an IC card by using a conventional semiconductor chip.
Fig. 2 is an illustration of an IC card fabricated by using a semiconductor chip of the present invention.
Fig. 3 is a process flow for fabricating an IC card by using a semiconductor chip of the present invention.
Fig. 4 is a process flow of an embodiment of the invention in which a semiconductor chip is separated from a semiconductor wafer.
Fig. 5 is a process flow of another embodiment of the invention in which a semiconductor chip is separated from a semiconductor wafer.
Fig. 6 is a process flow of still another embodiment of the invention in which a semiconductor chip is separated from a semiconductor wafer.
Fig. 7 is a process flow of still another embodiment of the invention in which a semiconductor chip is separated from a semiconductor wafer.
Fig. 8 is a process flow of still another embodiment of the invention in which a semiconductor chip is separated from a semiconductor wafer.
Fig. 9 is a cross sectional view of an IC tag fabricated by using a semiconductor chip of the invention.
Fig. 10 is a cross sectional view of an IC tag fabricated by using a semiconductor chip of the invention.
Fig. 11 is a process flow for fabricating an IC tag by using a semiconductor chip of the invention.
Fig. 12 is a characteristic diagram of an IC tag fabricated by using a semiconductor chip of the invention.

Here, the descriptions of the reference numerals in the respective drawings are as follows: 11- lead wire (antenna) , 12- Dumet wire, 13- glass tube, 14, 31 (14a, 31a)-IC chip (wireless chip), 100- semiconductor wafer, 110-grinding stone, 120- dicing tape, 130- adhesive, 140- vacuum chuck, 150- wafer ring, 160-microscope, 170- monitor, 180-alignment window 1, 181- alignment window 2, 190- dicing blade, 200- first groove, 210- second groove, 220- third groove, 230- semiconductor chip, 240- resist, 250- dry etching gas, 260- roller, 270- tape, 280- table, 290- heating unit, 300- control part, 310- anisotropic conductive adhesive, 320- anisotropic conductive particle, 330-silver paste wiring, 340- bump, 350- reinforcing board, 360- IC card, 370- coil, 380- PET material, 390- θ (angle).

### Detailed Description of Preferred Embodiment

The invention will be described below in detail by embodiments with reference to drawings.

### <Embodiment 1>

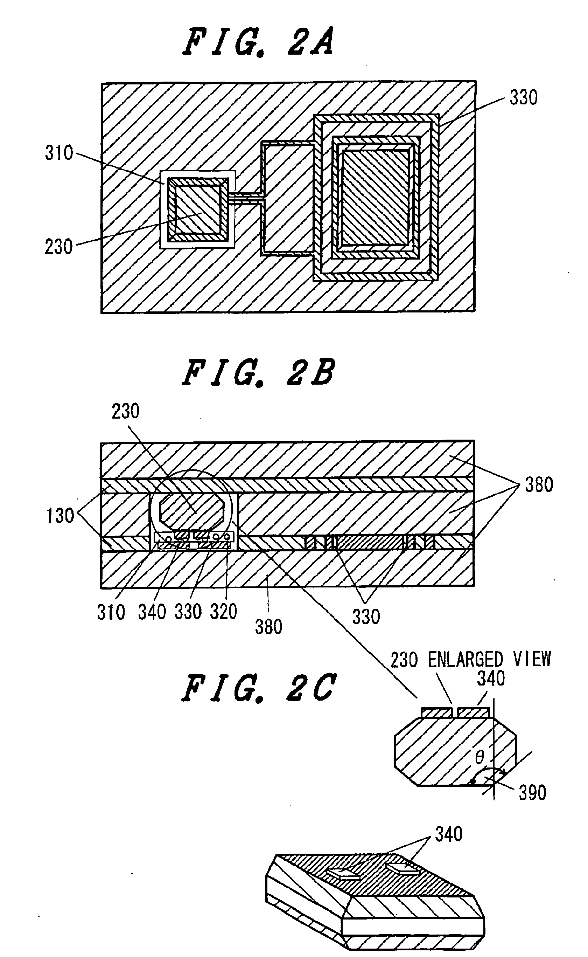

Figs. 2(a), (b), and (c) are a plan view and a cross sectional view to show the structure of a low-profile IC card in accordance with the invention and an enlarged view of a semiconductor chip. As shown in the drawings, edge portions on the side of a bump 340 formed in a device of a semiconductor chip 230 and edge portions of the back surface thereof are chamfered.

As shown in Fig. 2(c), the chamfering angle (slant angle) θ of each of the edge portions crossing a surface on which devices are formed of the semiconductor chip 230 and the back surface thereof is controlled within a range of 90° < θ < 180°, more preferably, 100° ≤ θ ≤ 135°. This semiconductor chip 230 is strongly held by a wiring 330 on a board 380 made of PET material by an anisotropic conductive adhesive 310 and hence is not separated from the wiring 330.

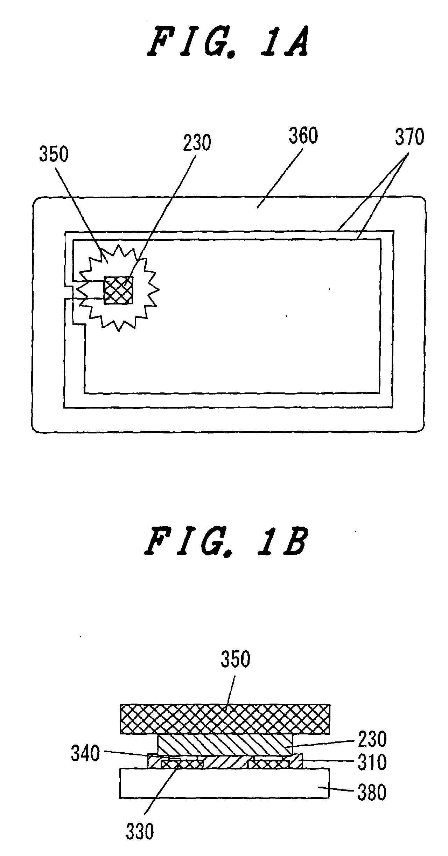

In this manner, the low-profile IC card of the invention has an IC chip 230 sandwiched between the PET materials 380 placed on upper and lower sides and fixed by an adhesive 130 and hence has a simple structure in which the PET materials 380 are bonded in such a way as to make the surfaces of the PET materials planar. By the adhesive 130, even if the PET material 380 is bent with respect to the semiconductor chip 230, the edge portions of the semiconductor chip 230 are not brought into contact with the PET material 380 and there is not a portion where stress is concentrated. Hence, according to the invention, the edges of the semiconductor chip 230 are chamfered to prevent the occurrence of chipping and a reinforcing board 350 which is essentially required in a conventional IC card shown in Fig. 1 is not required.

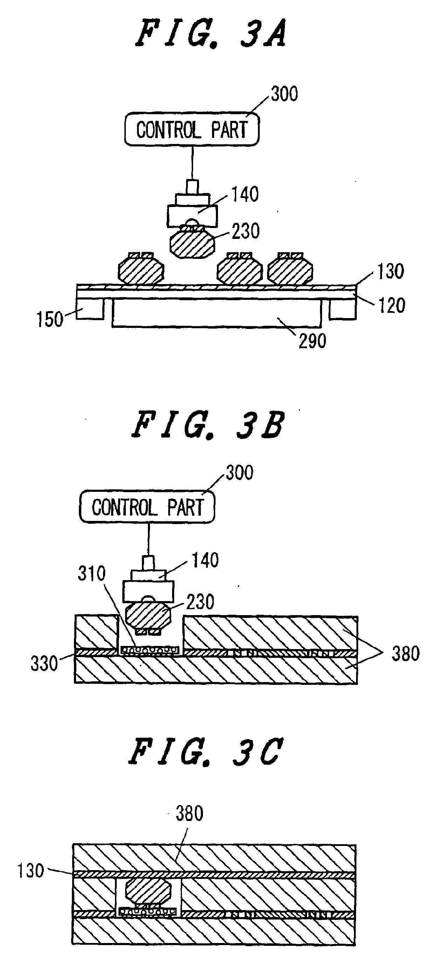

Fig. 3 shows a process flow for mounting'a low-profile IC card.

As shown in Fig. 3(a), the semiconductor chip 230 separated from a wafer by dicing is fixed on a heating unit 290 and then heat is applied to a dicing table 120 to reduce adhesiveness and then a vacuum chuck 140 controlled by a control part 300 holds and fixes the device surface of the semiconductor chip 230 by vacuum. Here, as for an example of a concrete fabricating method for chamfering the edges of the semiconductor chip 230 and for separating the semiconductor chip 230 from the wafer will be described in detail in embodiments 2 to 6.

The allowable sizes of chippings of the semiconductor chip separated from the wafer by dicing are about one half of the thickness of the chip and the semiconductor chip having a thickness of from 50 µm to 300 µm is used.

Next, as shown in Fig. 3(b), another vacuum chuck 140 holds, by vacuum, the back side of the semiconductor chip held previously by vacuum and then the semiconductor chip 230 is temporarily bonded and fixed to an anisotropic conductive adhesive 310 previously fixed on the PET material 380 and thereafter is finally bonded thereto.

Next, as shown in Fig. 3(c), the PET material 380 and the adhesive 130 are bonded and fixed to the back side of the finally bonded semiconductor chip 230. Thereafter, a predetermined pressure is applied to the whole of card to complete an IC card.

By use of an IC card structure produced in this manner, the IC card can be made a structural body in which when the device surface of the semiconductor chip is bonded to a silver paste wiring surface via the anisotropic conductive adhesive 310, even if pressure is applied to the whole of the chip, stress is not applied to the chip because the edges of the semiconductor chip are chamfered. Hence, this can provide an IC card that is thin in thickness and is resistant to bending and is excellent in mechanical strength.

### <Embodiment 2>

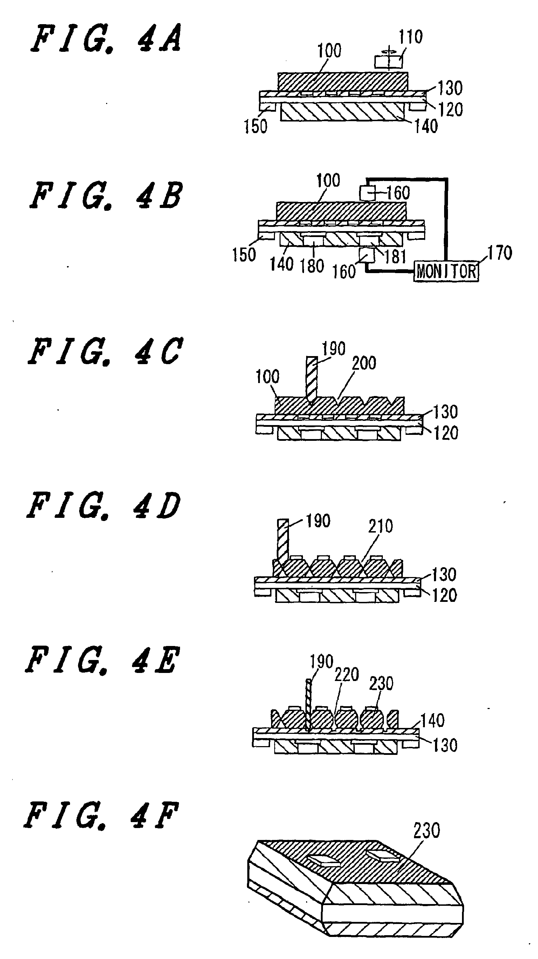

Fig. 4 shows a fabricating process flow of the invention for separating the semiconductor chip 230 from the wafer by dicing. First, as shown in Fig. 4(a), the surface of a semiconductor device laminated on a semiconductor wafer 100 is stuck with the adhesive 130 on a dicing tape 120 fixed to a wafer ring 150. Then, the dicing tape 120 is placed on and fixed by vacuum to the vacuum chuck 140 and then the back surface of the wafer is ground by a grinding stone 110.

Next, as shown in Fig. 4(b), a set of semiconductor wafer 100 which is held by the dicing tape 120 on the vacuum chuck 140 mounted with an alignment window 180 and is ground is held by vacuum on the vacuum chuck 140.

Next, the semiconductor wafer 100 is aligned within a first alignment window 180 with reference to a scribing line which can be seen on a monitor 170 by use of microscopes 160 mounted above and below a surface having the semiconductor device formed thereon and is previously formed on the surface of the semiconductor device. Then, while the vacuum chuck 140 is moved to the left and right to make the semiconductor wafer 100 parallel with reference to a scribing line formed on the surface of the semiconductor device also in a second alignment window 181, a dicing line is determined.

Next, as shown in Fig. 4(c), first grooves 200 are formed with reference to the scribing line formed on the back surface of the wafer (surface on which the semiconductor devices are not formed) by use of a first dicing blade 190 having a sharp tip. Thereafter, the dicing tape 120 is placed on a heating unit set at 100 °C to eliminate adhesiveness from the adhesive 130 of the dicing tape 120 and then the semiconductor wafer 100 having the grooves formed thereon is dismounted from the dicing tape 120.

Next, as shown in Fig. 4 (d) , the wafer is turned upside down and the surface on which the first grooves 200 are formed is stuck to the adhesive 130 side of the dicing tape 120 again mounted on the wafer ring 150. Then, second groves 210 are formed with reference to a scribing line formed on the surface on which the semiconductor devices are formed by a second dicing blade 190 having a sharp tip.

In this regard, the slant angles of the first and the second grooves 200, 210 can be easily adjusted by arbitrarily selecting the blade tip angles (vertical angle) θ' of the first and the second dicing blades used for forming the grooves. In this embodiment, the dicing blade having a blade tip angle θ' of 90° is used for the first and the second dicing blades, so that the first and the second grooves 200, 210 each having a slant angle θ' of 135° are formed. Moreover, in this case, the depths of the first and the second grooves (200, 210) are about 1/3 of the thickness of the semiconductor wafer, respectively.

Next, as shown in Fig. 4 (e) , a third dicing blade 190' having a flat tip form is aligned with the second groove 210, which is previously formed, and then third grooves 220 are formed by the dicing blade 190' having a width narrower than the width of the second groove to separate the semiconductor wafer 100 into the individual semiconductor chips 230.

Fig. 4 (f) shows an enlarged perspective view of the semiconductor chip 230 produced by this process. The above-described first grooves 200, the second grooves 210, and the third grooves 220 are formed in one direction and then the vacuum chuck 140 is turned 90° in the state where the semiconductor wafer 100 is held by vacuum and then grooves are formed in another direction.

By use of the above-described structure, the edge portions of the separated semiconductor chip are formed in the shape not to produce chippings. Hence, this can prevent the chip from being broken by stress concentration when the semiconductor chip is mounted on the IC card or the like, and therefore can fabricate the IC card having high mounting yield and high reliability.

### <Embodiment 3>

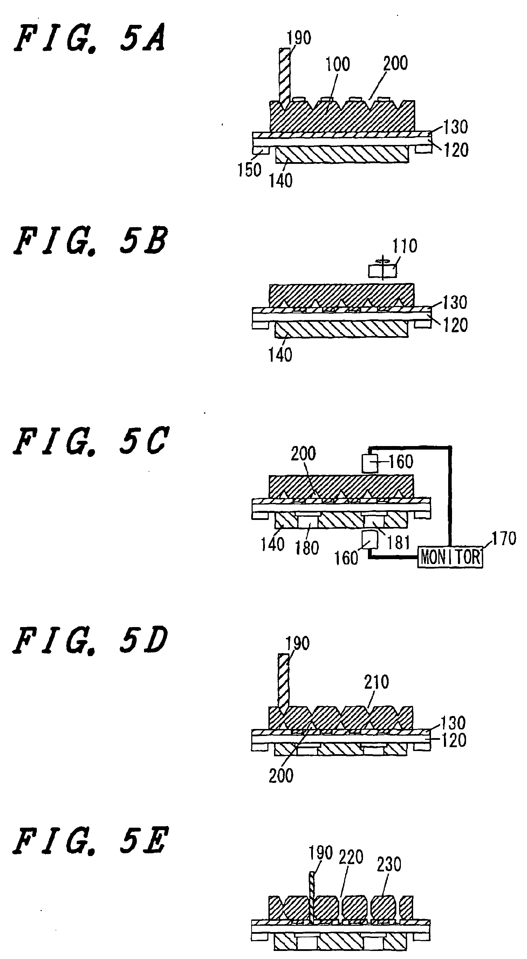

A method for separating the semiconductor chips from the wafer in this embodiment is fundamentally the same as that in the previous embodiment, but this method is different in that the order of performance of a step for forming the first grooves 200 and a step for forming the second grooves 210 is reversed. Description will be given with reference to process flow shown in Fig. 5.

First, as shown in Fig. 5(a), the dicing tape 120 mounted on the wafer ring 150 is stuck with the adhesive 130 to the back surface side of the semiconductor device laminated on the semiconductor wafer 100. Thereafter, the dicing tape 120 is fixed by vacuum to a first vacuum chuck 140 and then the first dicing blade 190 having a sharp tip is aligned with the scribing line formed in the semiconductor device laminated on the semiconductor wafer 100 and then the first grooves 200 are formed. Next, the dicing tape 130 is placed on the heating unit set at 100 °C and then the adhesiveness of the adhesive 130 on the dicing tape is removed and then the semiconductor wafer 100 having the grooves formed thereon is dismounted from the dicing tape 120 (not shown).

Next, as shown in Fig. 5 (b) , the wafer is turned upside down and the surface on which the first grooves are previously formed is stuck to the adhesive 130 side of the dicing tape 120 mounted on the wafer ring 150 and the dicing tape 120 is fixed by vacuum to a second vacuum chuck 140 and then the back surface of the wafer is ground by the grinding stone.

Next, as shown in Fig. 5(c), a set of semiconductor wafer 100 which is ground and held by the dicing tape 120 on a third vacuum chuck 140 mounted with alignment windows is held by vacuum on the vacuum chuck 140. Then, the set of ground semiconductor wafer 100 is aligned in the first alignment window 180 with reference to the first grooves which are previously formed on a monitor by use of microscopes 160 mounted above and below a surface on which the semiconductor devices are formed with reference to the first grooves which are previously formed. Then, while the vacuum chuck 140 is moved to the left and right to make the semiconductor wafer 100 parallel with reference to the grooves formed on the surface of the semiconductor device also in the second alignment window 181, the second groove forming line is determined.

Next, as shown in Fig. 5 (d) , the wafer surface having the first grooves formed thereon is stuck to the adhesive 130 side of the dicing tape 120 again mounted on the wafer ring and then second grooves 210 are formed by the second dicing blade 190 having a sharp tip with reference to the scribing line formed on the surface on which the semiconductor devices are formed.

Next, as shown in Fig. 5(e), the third dicing blade 190 having a flat tip is aligned with the second groove 210 which is previously formed and then third grooves are formed by the third dicing blade 190 having a narrow width than the width of the second groove to separate the semiconductor wafer 100 into individual semiconductor chips 230.

The use of the structure produced by the above-described process can realize an IC card which is excellent in mounting yield and reliability even if chips are separated with reference to any one surface of the top and bottom surfaces of the semiconductor wafer.

### <Embodiment 4>

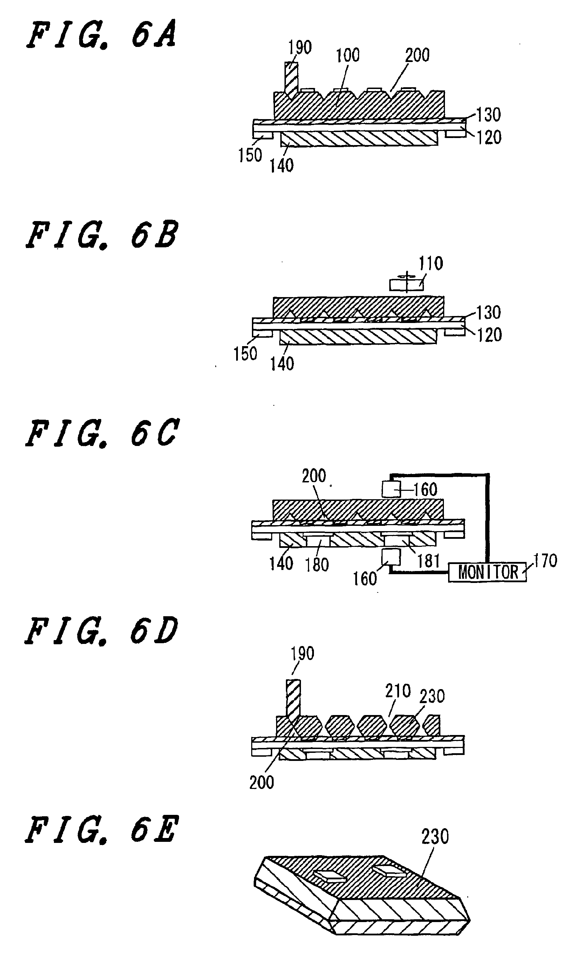

This embodiment is a method for cutting and separating the semiconductor chips 230 from the wafer by omitting the step of forming the third grooves 220 by the third dicing blade 190 in Fig. 5(e) shown in embodiment 3 and by using the step of forming the first grooves 200 by the first dicing blade 190 and the step of forming the second grooves 210 by second dicing blade 190. This embodiment will be described with reference to a fabricating process flow shown in Fig. 6.

As shown in Fig. 6 (a) , the back surface side of the semiconductor device laminated on the semiconductor wafer 100 is stuck with the adhesive 130 on the dicing tape 120 mounted on the wafer ring 150. Thereafter, the dicing tape 120 is fixed by vacuum to the vacuum chuck 140 and then the first grooves 200 are formed by the first dicing blade 190 having a sharp tip with the first dicing blade 190 aligned with the scribing line formed in the semiconductor device laminated on the semiconductor wafer 100. Next, the dicing tape 120 is placed on the heating unit (not shown) set at 100 °C to remove the adhesiveness of the adhesive 130 on the dicing tape and then the semiconductor wafer 100 having the grooves formed thereon is dismounted from the dicing tape 120 (a).

Next, as shown in Fig. 6 (b) , the wafer is turned upside down and the surface having the grooves formed thereon is stuck to the adhesive 130 side of the dicing tape 120 mounted on the wafer ring 150 and the dicing tape 120 is fixed by vacuum to the vacuum chuck 140 and then the back surface of the wafer is ground by the grinding stone 110.

Next, as shown in Fig. 6(c), a set of ground semiconductor wafer 100 which is held by the dicing tape 120 on the vacuum chuck 140 mounted with the alignment window 180 and whose back surface is ground is held by vacuum on the vacuum chuck 140. Then, the semiconductor wafer 100 is aligned in the first alignment window 180 with reference to the first grooves which are previously formed on the monitor 170 by use of microscopes 160 mounted above and below a surface on which the semiconductor devices are formed with reference to the first grooves which are previously formed. Thereafter, while the vacuum chuck 140 is moved to the left and right to make the semiconductor wafer 100 parallel with reference to the grooves formed on the surface of the semiconductor device also in another second alignment window 181, the second groove line is determined.

Next, as shown in Fig. 6 (d) , the semiconductor wafer 100 is fully diced to positions in contact with the groove bottoms of the first grooves which are previously formed by using the second dicing blade 190 having a flat tip to separate the semiconductor wafer 100 into individual semiconductor chips.

Fig. 6(e) shows a partially enlarged sectional schematic view of the semiconductor chip 230 produced by this fabricating process.

In this regard, in this embodiment, the first and the second dicing blades 190 each having a blade tip angle (vertical angle) θ' of 60° are used and the depth of the first groove 200 is nearly equal to one half of the thickness of the wafer and the semiconductor chips are separated from the wafer by the second grooves 210. The slant angle of the chamfered end portion of the semiconductor chip is 120°.

The semiconductor chip 230 produced in this manner is a structural body in which even if the semiconductor chip 230 is mounted on an IC card and then is subjected to a bending test in a higher level than an ordinary reliability test to apply stress directly to the chip, the stress is dispersed by the chamfered surfaces because the chamfered surfaces formed on the edge portions of the top and bottom of the chip agree with each other at the center of the thickness of the chip. Hence, this semiconductor chip 230 produced in this manner can realize an IC card having excellent reliability. Moreover, the chips can be also fabricated by two dicing processes, which leads to reducing a fabrication time.

### <Embodiment 5>

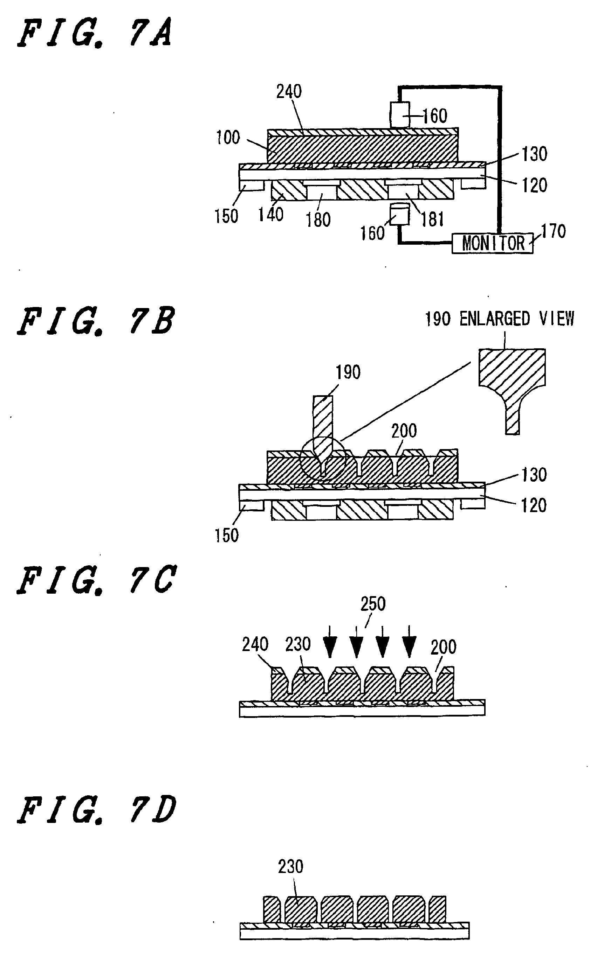

In this embodiment, as a method for cutting and separating the semiconductor chips from the wafer is shown a method for fabricating a chip by which first grooves 200 of a depth extending at least over the center point of the thickness of the wafer are formed by using a dicing blade having a flat portion at a tip and a vertical angle connected to the flat portion and controlled to a predetermined angle θ' and by which the wafer of a remaining depth is cut off by dry etching. This embodiment will be described below with reference to a fabricating process flow shown in Fig. 7.

As shown in Fig. 7 (a), a resist 240 is applied to the opposite surface of the semiconductor device laminated on the semiconductor wafer 100 (back surface of the wafer) and is dried and then the surface of the semiconductor device is stuck to the adhesive 130 side of the dicing tape 120 mounted on the wafer ring 150.

Thereafter, the dicing tape 120 is fixed by vacuum to the vacuum chuck 140 mounted with the alignment window 180 and then the semiconductor wafer is aligned in the firs alignment window 180 with reference to the scribing line formed on the surface of the semiconductor device on the monitor 170 by use of microscopes 160 mounted above and below the surface on which the semiconductor devices are formed. Then, while the vacuum chuck 140 is moved to the left and right to make the semiconductor wafer 100 parallel with reference to the scribing line formed on the surface of the semiconductor device also in another second alignment window 181, the positions where the first grooves 200 are to be formed are determined.

Next, as shown in Fig. 7(b), the first grooves 200 are formed by the dicing blade 190 having a blade tip whose top is formed in a protruding shape (flat portion) and is curved on the protruding side and formed in a polygon (here shown as being regulated to a predetermined vertical angle θ'). At this time, the end portion of the formed first groove 200 can be formed in a predetermined shape by selecting the top shape of the dicing blade.

Next, as shown in Fig. 7(c), the first grooves 200 which are previously formed are etched by well-known gas 250 for dry etching by using the resist 240 as a mask to separate the semiconductor wafer 100 into individual semiconductor chips.

The use of the structure described above can realize the separation of the chips by one operation of dry etching. Hence, this is a method for dicing the semiconductor wafer by which the time required to separate the chips can be reduced and by which damages do not remain in the separated chips to prevent the chip ends from being chipped. Therefore, when an IC card is fabricated by use of this chip, it is possible to prevent the chip from being broken in a mounting process and hence to enhance yield and to realize the IC card having excellent reliability.

### <Embodiment 6>

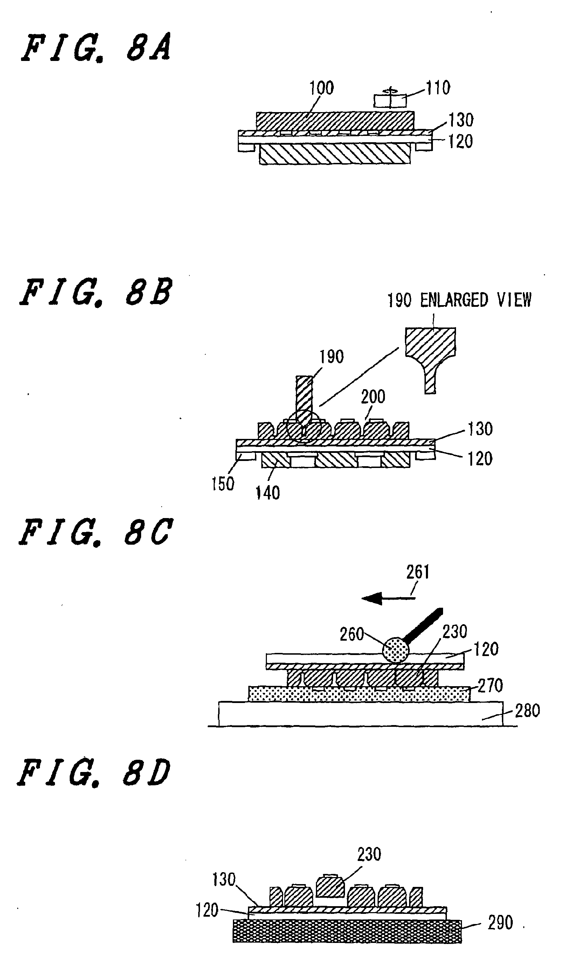

This embodiment uses the cleavage of a crystal in place of a process for cutting and separating the semiconductor chips by dry etching in the embodiment 5. This embodiment will be described with reference to a fabrication process flow shown in Fig. 8.

First, as shown in Fig. 8(a), the surface of the semiconductor device laminated on the semiconductor wafer 100 is stuck to the adhesive 130 side of the dicing tape 120 mounted on the wafer ring 150. Next, the dicing tape 120 is fixed by vacuum to the vacuum chuck 140 and then the back surface of the wafer is ground by the grinding stone 110.

Next, as shown in Fig. 8(b), the first grooves 200 are formed by the dicing blade 190 whose top is protruded and curved on the protruding side and is formed in the shape of a polygon (like the process of Fig. 7(b) in embodiment 5). At this time, the end portion of the formed first groove 200 can be formed into a predetermined shape by selecting the top shape of the dicing blade.

Next, as shown in Fig. 8(c), the semiconductor wafer 100 is dismounted from the vacuum chuck 140 and is turned upside down and placed on a tape 270 having a thickness of about 1 mm and placed on a table 280. Then, pressure is applied in parallel to the groove forming line by a roller 260 to the dicing tape 120 side stuck to the back surface of the semiconductor wafer 100 having groove formed thereon, thereby cleaving the semiconductor wafer 100 at the grooves to separate the semiconductor wafer 100 into the individual semiconductor chips 230.

Next, as shown in Fig. 8(d), the individually separated semiconductor chips 230 are yet stuck to the dicing tape 120 by the adhesive 130. However, the whole semiconductor chips 230 are turned upside down in this state and are placed on the heating unit 290 previously set at 100 °C to be heated, whereby the adhesiveness of the adhesive 130 of the dicing tape 120 are reduced and the semiconductor chips 230 are separated.

The semiconductor chip produced by this method can become a semiconductor chip having such resistance to bending that cannot be provided only by the ordinary dicing operation. Moreover, this semiconductor chip has a structure in which damage does not remain on the cut end portion of the semiconductor chip and hence an IC card having excellent mechanical strength can be realized by mounting this chip on the IC card.

The thickness of the semiconductor chip used for the above-described IC card is from 50 µm to 300 µm and this can realize a low-profile IC card.

### <Embodiment 7>

This embodiment shows examples in which the semiconductor chips 230 produced in the above-described embodiments 2 to 6 are mounted as IC chips on semiconductor tags (IC tags). The IC tag, as is well known, is an electronic device that communicates information stored in a memory in the semiconductor chip to outside readers or writers via an antenna on a noncontact basis to recognize an object.

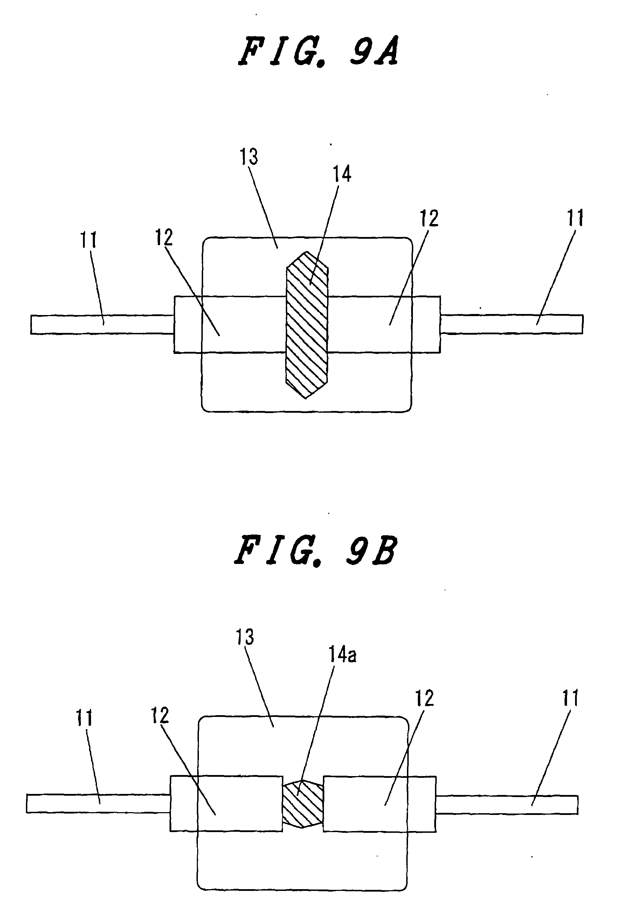

Fig. 9 schematically shows the sectional structure of the IC tag. An IC chip 14 mounted on this IC tag is a semiconductor chip also called a wireless chip and in this embodiment, the semiconductor chips 230 produced in the above-described embodiments 2 to 6 are used as IC chips (wireless chips) 14. In the drawing, a lead wire 11 is connected to and integrated with a base (Dumet wire) 12 and becomes an antenna.

The IC chip (wireless chip) 14 that is supplied with electric power from the antenna thereby to be operated has a structure in which it is sandwiched between the Dumet wires. Glass 13 is formed in a tube and the wireless chip and a part of Dumet wire are sealed by the glass 13. In Fig. 9(a), the length of diagonal of the wireless chip 14 is larger than the diameter of the Dumet wire 12 and in Fig. 9(b), the length of diagonal of a small-size wireless chip 14a is smaller than the diameter of the Dumet wire 12.

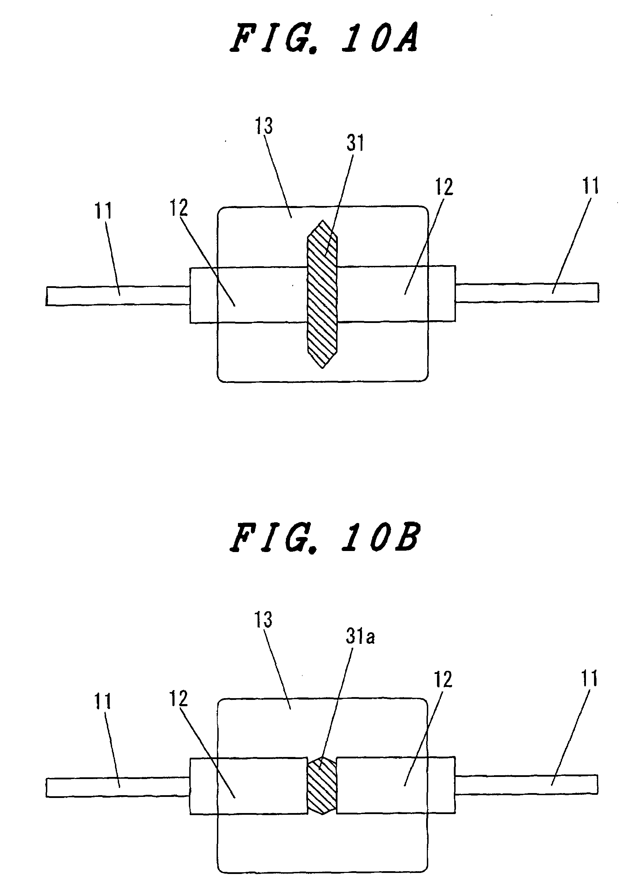

Fig. 10(a) and Fig. 10(b) show examples using a low-profile wireless chip 31a in which the IC chip (wireless chip) 14 in Fig. 9 is formed of a thin film.

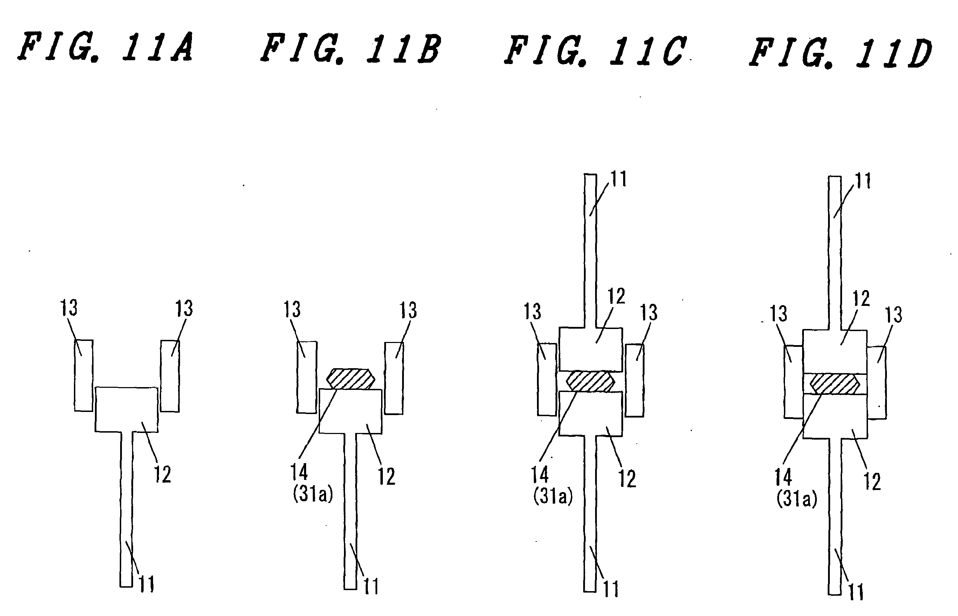

Next, the outline of a method for fabricating an IC tag will be described with reference to a process flow shown in Fig. 11. This example, as shown in Fig. 9(b) and Fig. 10 (b) , shows a case of mounting a chip in which the length of diagonal of the wireless chip is smaller than the diameter of the Dumet wire 12.

As shown in Fig. 11 (a) , first, the top end of the Dumet wire 12 connected to the lead wire 11 and vertically erected is inserted into the glass tube 13 from below. Next, as shown in Fig. 11(b), the wireless chip 14 (31a) is placed on the Dumet wire 12 inserted into the glass tube 13.

Next, as shown in Fig. 11(c), another Dumet wire 12 is inserted into the glass tube 13 from above to sandwich the wireless chip 14 (31a). At this time, pressure applied to the Dumet wire 12 is from 5 MPa to 10 MPa. With this, the respective electrodes mounted on the principal surface and the back surface of the wireless chip are electrically connected to the Dumet wire 12.

Thereafter, as shown in Fig. 11(d), the glass tube 13 is heated to high temperature to be melted, thereby being bonded to the Dumet wire 12.

In the IC tag produced in this manner, the edges of the chip 14 are regulated to a preferable 'chamfering angle andhence give little damage to the chip at the time ofmounting the IC chip, in particular, at the time of sealing the glass tube. Hence, this can increase fabrication yield and enhance the reliability of the IC tag.

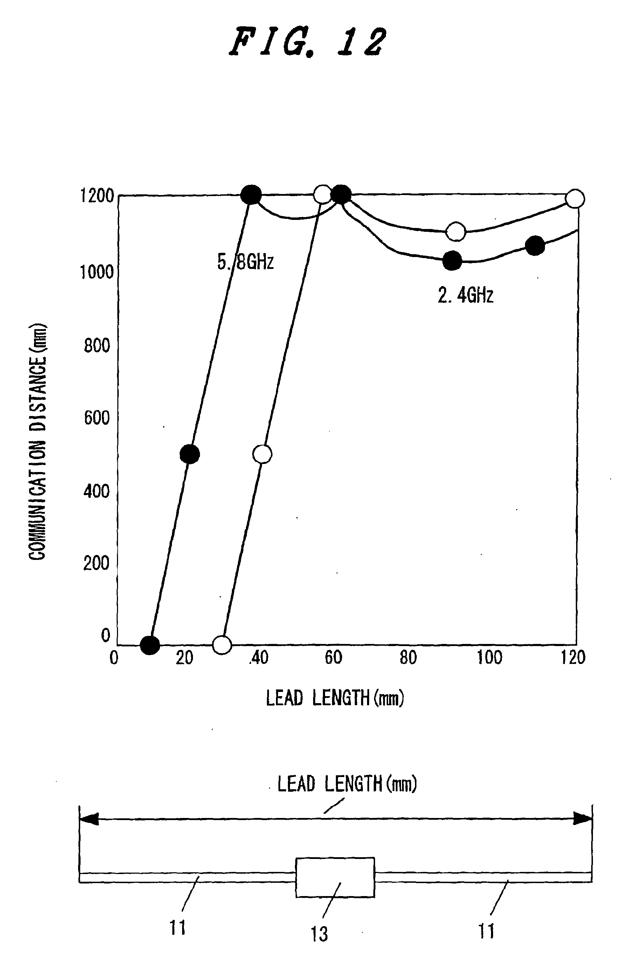

Next, the influence exerted on a communication distance by the length of the lead wire (antenna) 11 of the IC tag will be described with reference to Fig. 12. The lateral axis of this drawing shows the length of the lead wire of the IC tag (transponder) and the vertical axis shows a communication distance between the transponder and a reader.

As for the length of the lead wire, a length of one half of a carrier wave is most preferable as resonance condition (about 6 cm at 2.45 GHz) and maximizes the communication distance. As the length of the lead wire becomes shorter than this, the communication distance decreases but even if the lead wire becomes longer than this, the communication distance does not extremely decrease. The length of the lead wire ranging from 1/2 wavelength to one wavelength of the carrier wave can be used.

### Industrial Applicability

As described above in detail, if a semiconductor device in accordance with the present invention in which both surfaces of the semiconductor chip are chamfered at a specified angle is mounted, for example, on an IC card, the IC card has a structure capable of resisting mechanical breakage. Hence, it is possible to produce a low-profile IC card that does not need a reinforcing board and has high reliability. In addition, it is also possible to reduce fabrication cost because the reinforcing board for providing mechanical strength is not required.

Moreover, if the semiconductor device in accordance with the invention is used for the wireless chip of an IC tag, it is possible to'produce an IC tag having high fabrication yield and also high reliability in a device.

## Claims

1. A semiconductor device in which at least edge portions of a surface on which a device is formed of a semiconductor chip and a back surface thereof are chamfered to have a slant surface having a chamfering slant angle θ, respectively, where 90° < θ < 180°.

2. The semiconductor device as claimed in claim 1, wherein the chamfering slant angle θ is not less than 100° and not more than 135°.

3. A method for fabricating a semiconductor device, the method comprising a step of cutting and separating a semiconductor chip from a semiconductor wafer by dicing, wherein the dicing comprises:
a step of forming a first groove having a depth of at least 1/2 of a thickness of the semiconductor chip along a scribing line from one surface of the semiconductor wafer by use of a first dicing blade having a predetermined vertical angle θ'; and
a step of forming a second groove along the scribing line by use of a second dicing blade having the predetermined vertical angle θ' from a back surface of the semiconductor wafer.

4. The method for fabricating a semiconductor device as claimed in claim 3, comprising a step of cutting and separating the semiconductor chip having an edge portion having a chamfering slant angle θ, where 100° ≤ θ ≤ 135°, by use of the first and the second dicing blade each having the vertical angle θ' ranging from 20° to 90°.

5. A method for fabricating a semiconductor device, the method comprising a step of cutting and separating a semiconductor chip from a semiconductor wafer and including dicing, wherein the step of cutting and separating the semiconductor chip comprises:
a step of forming a groove having a depth of at least 1/2 of a thickness of the semiconductor chip along a scribing line from one surface of the semiconductor wafer by use of a dicing blade having a predetermined vertical angle θ'; and
a step of turning the semiconductor wafer upside down and applying pressure to a back surface of the semiconductor wafer to cleave and separate the semiconductor chip at the groove.

6. A method for fabricating a semiconductor device, the method comprising a step of cutting and separating a semiconductor chip from a semiconductor wafer and including dicing, wherein the step of cutting and separating the semiconductor chip comprises:
a step of forming a groove having a depth of at least 1/2 of a thickness of the semiconductor chip along a scribing line from one surface of the semiconductor wafer by use of a dicing blade having a predetermined vertical angle θ'; and
a step of separating the groove by dry etching.

7. An IC card mounted with the semiconductor as claimed in claim 1 or claim 2.

8. An IC tag mounted with the semiconductor as claimed in claim 1 or claim 2.
